(19) Europäisches Patentamt
European Patent Office
Office européen des brevets

(11) EP 3 809 205 A1

(12) DEMANDE DE BREVET EUROPEEN

(43) Date de publication:
**21.04.2021 Bulletin 2021/16**

(51) Int Cl.:
***G03F 7/20*** *(2006.01)* ***G01B 15/04*** *(2006.01)*
***G01B 15/08*** *(2006.01)* ***H01J 37/26*** *(2006.01)*

(21) Numéro de dépôt: **20201618.4**

(22) Date de dépôt: **13.10.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **14.10.2019 FR 1911414**

(71) Demandeurs:
- **Commissariat à l'Energie Atomique et aux Energies Alternatives**
**75015 Paris (FR)**
- **Université Grenoble Alpes**
**38400 Saint-Martin-d'Hères (FR)**
- **Centre national de la recherche scientifique**
**75016 Paris (FR)**

(72) Inventeur: **RECHE, Jérôme**
**38054 GRENOBLE (FR)**

(74) Mandataire: **Hautier, Nicolas**
**Cabinet Hautier**
**20, rue de la Liberté**
**06000 Nice (FR)**

# (54) PROCÉDÉ DE FABRICATION D'UN ÉTALON DE RUGOSITÉ DE CONTOUR

(57) L'invention concerne notamment un procédé de fabrication d'un étalon de rugosité de contour comprenant les étapes suivantes :
- définir (10) une densité spectrale de puissance souhaitée $PSD_{souhaitée}$ pour la rugosité d'un contour d'au moins un motif donné,
- fabriquer (20) au moins un motif de référence à partir d'un dessin de référence de l'au moins un motif donné et avec des conditions données de fabrication $F_{référence}$, le dessin de référence présentant une rugosité nulle,
- effectuer une mesure (21) $M_{référence}$, avec des conditions de mesure $E_{référence}$, de la rugosité du motif de référence fabriqué,
- sur la base de la mesure $M_{référence}$, calculer (22) la densité spectrale de puissance $PSD_{référence}$ de la rugosité du motif de référence fabriqué;
- calculer (30) une densité spectrale de puissance corrigée $PSD_{corrigée}$ telle que $PSD_{corrigée} = PSD_{souhaitée} - PSD_{référence}$,
- définir (40) un dessin corrigé présentant une rugosité respectant la $PSD_{corrigée}$,
- fabriquer (50) au moins un motif étalon à partir dudit dessin corrigé, et avec lesdites conditions données de fabrication $F_{référence}$.

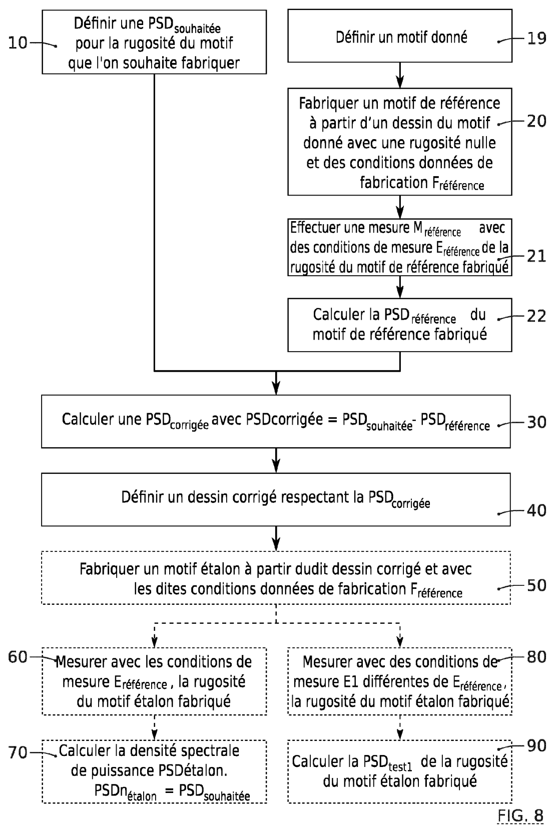

FIG. 8

EP 3 809 205 A1

**Description**

DOMAINE TECHNIQUE DE L'INVENTION

La présente invention concerne le domaine de la fabrication d'étalons de rugosité. Elle trouve notamment pour application particulièrement avantageuse le domaine de la calibration des équipements de fabrication de dispositifs de taille micrométrique ou nanométrique. Elle trouve également pour application le test ou la comparaison des performances en termes de rugosité de techniques ou d'équipements servant à réaliser de tels dispositifs de taille micrométrique ou nanométrique.

L'invention s'avère particulièrement avantageuse dans les domaines technologiques de la microélectronique, des micro et nanotechnologies ainsi que de la photonique.

ÉTAT DE LA TECHNIQUE

Dans de nombreux domaines technologiques, par exemple impliquant des motifs de taille micro ou nanométrique, la rugosité des contours des motifs est un paramètre important.

Par exemple, dans le cas de la réalisation de lignes, le motif formé par chaque ligne présente des flancs dont la rugosité varie le long de la ligne.

La figure 1 illustre en perspective un réseau de motifs 1, chaque motif 1 formant une ligne en trois dimensions (3D) présentant deux flancs 2. Dans ce type de réseau, on cherche à maîtriser plusieurs dimensions critiques, telle que la largeur ($CD_{largeur}$) d'une ligne, l'espace ($CD_{espace}$) entre deux lignes adjacentes ou le pas (Pitch) du réseau qui est lié aux deux dimensions précédentes. Ces dimensions critiques $CD_{largeur}$, $CD_{espace}$ et Pitch sont illustrées en figure 2 qui est une vue du dessus du réseau illustré en figure 1, dans un cas idéal.

Tout procédé induit de la rugosité de ligne plus généralement désignée rugosité de contour. Cette rugosité est un défaut de type aléatoire propre à chaque équipement, au procédé mis en œuvre et aux matériaux utilisés par exemple. Ainsi il n'est pas possible de déterminer un déplacement ou un changement de la taille de ligne à un endroit donné. La figure 3 est une vue du dessus du réseau illustré en figure 1 et qui illustre de manière schématique la rugosité de ligne, c'est-à-dire le changement de largeur de ligne ou localement de sa position, tout le long de celle-ci.

Il existe un besoin général consistant à mieux contrôler la rugosité des lignes ou plus généralement la rugosité des contours réalisés.

La mesure de rugosité le long d'un contour tel qu'une ligne de dimension micro ou nanométrique se fait généralement avec un microscope électronique à balayage (MEB). D'autres techniques existent pour réaliser de telles mesures. L'accumulation de mesures le long du contour mène à l'obtention d'une densité spectrale de puissance, habituellement désignée par le vocable anglais « Power Spectral Density ». Dans la suite de la description, une densité spectrale de puissance sera désignée par l'acronyme PSD.

Dans le domaine de la mesure de rugosité, la PSD est une représentation statistique de l'importance de la rugosité pour chacune des fréquences spatiales analysées. La figure 4 illustre une PSD. L'axe des abscisses représente le nombre d'onde Kn qui est lié à la fréquence spatiale des rugosités. L'axe des ordonnées, correspondant à la puissance, exprime l'amplitude et la redondance de chacune des fréquences ou nombre d'onde.

La PSD de la figure 4 été obtenue après extraction du bord de six lignes sur une image issue d'un microscope électronique à balayage, l'image présentant une longueur de 2$\mu$m ($10^{-6}$ mètres) avec une taille de pixel de 0.8nm ($10^{-9}$ mètres). La taille de pixel étant ici le pas entre chaque prise de mesure ou la résolution d'amplitude de variations détectables.

L'obtention d'une PSD est connue de l'homme du métier. Pour obtenir des points de mesure d'un contour et calculer une PSD à partir de ce dernier on pourra par exemple se référer à la publication suivante : Bunday, B. D., Bishop, M., Villarrubia, J. S. and Vladar, A. E., "CD-SEM measurement line-edge roughness test patterns for 193-nm lithography," Microlithogr. 2003, 674-688, International Society for Optics and Photonics (2003).

Comme indiqué ci-dessus, la rugosité de ligne est un défaut de type aléatoire et il n'est pas possible de déterminer un déplacement ou un changement de la taille d'une ligne exactement à un endroit donnée du contour. Cependant la PSD est le reflet statistique des fluctuations du bord du contour.

Il est aujourd'hui possible de créer des dessins de rugosité à partir d'un modèle mathématique de PSD. Un exemple de dessin est illustré en figure 5. L'équation ci-dessous est un exemple d'un tel modèle mathématique, qui a été décrit dans la publication Reche, J., Besacier, M., Gergaud, P. and Blancquaert, Y., "Manufacturing of roughness standard samples based on ACF/PSD model programming," 34th Eur. Mask Lithogr. Conf., U. F. Behringer and J. Finders, Eds., 50, SPIE, Grenoble, France (2018) mentionnée ci-dessus.

$$P_n = \frac{\Delta y}{2\pi N}\sigma^2 \left[\sum_{m=0}^{N-1}(2-\delta_m)\, e^{-\left|\frac{m\Delta y}{\xi}\right|^{2\alpha}} cos(\,k_n m\Delta y)\,(N-m)\right]$$

Cette équation est une PSD obtenue sur la base de la fonction d'autocorrélation avec trois paramètres : $\alpha$ le facteur de rugosité, $\xi$ la longueur de corrélation, $\sigma$ la déviation standard et où N est le nombre de points, $\Delta y$ l'écart entre les points et kn le nombre d'onde.

Lorsque le dessin défini à partir d'une PSD est reproduit réellement, par exemple par lithographie, la rugosité finale obtenue sur ce motif réel n'est pas celle du dessin souhaité. Cela est notamment dû au fait que le procédé a inévitablement une rugosité naturelle, i.e., la rugosité induite par le procédé sans ajout de rugosité programmée. La figure 6 illustre cette problématique. Comme illustré sur cette figure 6, après avoir défini une PSD souhaitée (étape 10), on définit un dessin correspondant à cette PSD souhaitée (étape 11), c'est-à-dire un dessin dont le bord du contour présente une fluctuation qui respecte la distribution induite par la PSD. On fabrique ensuite les motifs sur la base de ce dessin souhaité (étape 12). Ensuite, on mesure M1 la rugosité des motifs fabriqués (étape 13). Du fait de la rugosité naturelle liée au procédé de fabrication, la rugosité des motifs fabriqués est différente de la rugosité souhaitée. Il s'ensuit que la PSD calculée sur la base des mesures M1 de rugosité effectuée sur les motifs fabriqués est différente de la PSD souhaitée (étape 14).

Un objectif de la présente invention est donc de proposer une solution permettant de limiter, voire de supprimer, au moins certains des inconvénients des solutions connues.

En particulier, un objectif de l'invention serait de parvenir à fabriquer un étalon de rugosité présentant des caractéristiques prédéterminées en termes de rugosité.

Un autre objectif de la présente invention serait de proposer une méthode permettant de tester ou de comparer les performances en termes de rugosité avec une plus grande simplicité et/ou une plus grande fiabilité.

Les autres objets, caractéristiques et avantages de la présente invention apparaîtront à l'examen de la description suivante et des dessins d'accompagnement. Il est entendu que d'autres avantages peuvent être incorporés.

## RÉSUMÉ DE L'INVENTION

Pour atteindre cet objectif, selon un mode de réalisation on prévoit un procédé de fabrication d'un étalon de rugosité de contour comprenant les étapes suivantes :

- définir une densité spectrale de puissance souhaitée $PSD_{souhaitée}$ pour la rugosité d'un contour ;
- fabriquer au moins un motif de référence à partir d'un dessin de référence de l'au moins un motif donné, le dessin de référence présentant une rugosité nulle ;
- effectuer une mesure $M_{référence}$ de la rugosité du motif de référence fabriqué ;
- sur la base de la mesure $M_{référence}$, calculer (22) la densité spectrale de puissance $PSD_{référence}$ de la rugosité du motif de référence fabriqué
- calculer une densité spectrale de puissance corrigée PSD corrigée telle que $PSD_{corrigée} = PSD_{souhaitée} - PSD_{référence}$ ;
- définir un dessin corrigé présentant une rugosité respectant la $PSD_{corrigée}$.

Il est alors possible de fabriquer au moins un motif étalon à partir dudit dessin corrigé, c'est-à-dire en prenant pour consigne ce dessin corrigé, et avec lesdites conditions données de fabrication $F_{référence}$.

Ainsi, la rugosité naturelle induite par les conditions de fabrication sont prises en compte en amont, lors de la création du dessin qui va servir à fabriquer l'étalon. La rugosité finale de l'étalon fabriqué correspond alors à la rugosité souhaitée. Plus précisément, on observe que pour l'étalon fabriqué la distribution de la fluctuation des bords du contour en fonction des fréquences spatiales correspond à la PSD souhaitée.

Ainsi, l'invention permet de fabriquer des motifs dont la rugosité correspond à la PSD souhaitée.

Par ailleurs, afin d'effectuer le calibrage ou le test d'un équipement de mesure, il suffit que cet équipement mesure le motif étalon dont la rugosité est connue. L'invention permet de simplifier et de réduire la durée des procédés de calibrage ou de tests par rapport aux solutions connues qui nécessitent la mesure à la fois des motifs de référence et des motifs fabriqués sur la base de la PSD souhaitée.

En outre, l'invention présente également comme avantage significatif d'être plus fiable que les solutions connues. En effet, avec les solutions connues, les tests de capacité de résolution des équipements de mesure sont souvent faussés.

En effet, avec la solution de l'art antérieur décrite ci-dessus et illustrée en figure 7, l'équipement de mesure de rugosité doit effectuer la mesure M1 qui dépend de la rugosité du dessin souhaité additionnée de la rugosité naturelle.

Or, la sensibilité d'un équipement en termes de rugosité n'est pas forcément linéaire. Ainsi, il peut-être plus simple de détecter la rugosité « A » additionnée d'une rugosité « B » que la rugosité « A » mesurée seule. Avec la solution illustrée en figures 7, l'équipement mesure uniquement les rugosités A+B sans jamais mesurer la rugosité A seule. Cela conduit à fausser le test de la capacité de résolution de l'équipement de mesure sur la rugosité A. Au contraire, l'invention permet de fabriquer un motif étalon présentant la rugosité A. L'équipement mesurera cette rugosité A. Le test de capacité ne sera donc pas faussé.

De manière facultative, le procédé peut en outre présenter au moins l'une quelconque des caractéristiques suivantes :

Selon un exemple, la $PSD_{souhaitée}$ est définie de sorte que pour chaque fréquence ou nombre d'onde de la $PSD_{souhaitée}$: $PSD_{souhaitée} \geq PSD_{référence}$.

Selon un exemple, le procédé comprend également une étape de fabrication du motif de référence à partir d'un dessin de référence d'un motif donné est effectuée avec des conditions données de fabrication $F_{référence}$.

Selon un exemple, le procédé comprend également une étape de mesure $M_{référence}$ de la rugosité du motif de référence est effectuée avec des conditions de mesure $E_{référence}$.

Selon un exemple, le contour est une ligne droite ou une pluralité de lignes droites.

Selon un exemple, la PSD exprime ou conditionne la rugosité de largeur de ligne (Line Width Roughness - LWR). Selon un exemple, la PSD exprime ou conditionne la rugosité de bord de ligne (Line Edge Roughness - LER).

Selon un exemple, l'au moins un motif forme un réseau de lignes parallèles.

Selon un exemple, le contour est une ligne courbe. Selon un exemple, le contour est une ligne courbe entièrement fermée ou dont une partie seulement est fermée. Selon un exemple, l'au moins un motif forme par exemple au moins l'un parmi un trou, un plot et un pylône.

Selon un mode de réalisation, le procédé comprend en outre l'étape suivante : Effectuer une mesure M1, avec des conditions de mesure E1 différentes des conditions de mesure de $E_{référence}$, de la rugosité du motif étalon fabriqué.

Selon un exemple, la mesure M1 de la rugosité du motif étalon fabriqué est effectuée avec des conditions de mesure E1 qui diffèrent des conditions de mesure de $E_{référence}$ par au moins l'un des paramètres suivants :

- équipement de mesure utilisé,
- fréquence d'échantillonnage,
- longueur mesurée ou longueur spatiale de la mesure (taille le long de la ligne),
- vitesse de mesure,
- nombre de contours mesurés.

Selon un exemple, le procédé comprend en outre l'étape suivante :

- sur la base de la mesure M1, calculer la densité spectrale de puissance $PSD_{test1}$ de la rugosité du motif étalon fabriqué ;
- comparer $PSD_{test1}$ et $PSD_{souhaitée}$.

Selon un autre mode de réalisation, le procédé comprend en outre les étapes suivantes :

- fabriquer au moins un motif test à partir dudit dessin corrigé (c'est-à-dire en prenant pour consigne ce dessin corrigé) et avec des conditions de fabrication F2 différentes des conditions de fabrication $F_{référence}$ ;
- effectuer une mesure M2, avec les conditions de mesure $E_{référence}$, dela rugosité du motif test fabriqué avec les conditions de fabrication F2 :
- sur la base de la mesure M2, calculer la densité spectrale de puissance $PSD_{test2}$ de la rugosité du motif test fabriqué avec les conditions de fabrication F2 ;
- comparer PSDtest2 et $PSD_{souhaitée}$.

Un autre aspect concerne un procédé de test des performances des conditions de mesure de rugosité d'un contour d'un motif. Ce procédé comprend les étapes suivantes :

- fabriquer un étalon de rugosité de contour en effectuant les étapes suivantes :
  - définir une densité spectrale de puissance souhaitée $PSD_{souhaitée}$ pour la rugosité du contour de l'au moins un motif donné,
  - fabriquer au moins un motif de référence à partir d'un dessin de référence de l'au motif donné et avec des conditions données de fabrication $F_{référence}$, le dessin de référence présentant une rugosité nulle,
  - effectuer une mesure $M_{référence}$, avec des conditions de mesure $E_{référence}$, de la rugosité du motif de référence fabriqué,

- sur la base de la mesure $M_{référence}$, calculer la densité spectrale de puissance $PSD_{référence}$ de la rugosité du motif de référence fabriqué ;
- calculer une densité spectrale de puissance corrigée $PSD_{corrigée}$ telle que $PSD_{corrigée}$ - $PSD_{souhaitée}$ - $PSD_{référence}$,
- définir un dessin corrigé présentant une rugosité respectant la $PSD_{corrigée}$,
- fabriquer au moins un motif étalon à partir dudit dessin corrigé et avec lesdites conditions données de fabrication $F_{référence}$,
- effectuer une mesure M1, avec des conditions de mesure E1 différentes de $E_{référence}$, la rugosité du motif étalon fabriqué,
- sur la base de la mesure M1, calculer la densité spectrale de puissance $PSD_{test1}$ de la rugosité du motif étalon fabriqué.

Cette comparaison permet de tester les performances en termes de mesure des conditions E1 ou de comparer ces performances à celles des conditions de mesure $E_{référence}$.

Par exemple, dans le but de tester la précision d'un équipement de mesure EM1, les conditions E1 se basent sur l'équipement de mesure $EM_{référence}$ différent de l'équipement de mesure EM1 utilisé dans les conditions de mesure $E_{référence}$.

De même, on peut modifier la fréquence d'échantillonnage de mesure entre les conditions E1 et $E_{référence}$ afin d'estimer le gain ou la perte de précision en fonction de la variation de la fréquence d'échantillonnage.

Il est ainsi possible de sélectionner les conditions de mesure les plus pertinentes.

Par ailleurs, il est également possible de calibrer un équipement de mesure donnée pour l'amener à une performance souhaitée, par exemple identique à d'autres équipements.

Selon un mode de réalisation l'équation ci-dessous est utilisée pour calculer la PSD:

$$P_n = \frac{\Delta y}{2\pi N}\sigma^2 \left[\sum_{m=0}^{N-1}(2-\delta_m)\; e^{-\left|\frac{m\Delta y}{\xi}\right|^{2\alpha}} cos(\,k_n m\Delta y)\,(N-m)\right]$$

Dans cette équation, $\alpha$ est le facteur de rugosité, $\xi$ est la longueur de corrélation, $\sigma$ est la déviation standard, N est le nombre de points, $\Delta y$ est l'écart entre les points et kn est le nombre d'onde.

Selon un autre mode de réalisation, la $PSD_{souhaitée}$ n'est pas définie à partir de l'équation ci-dessus. Selon un exemple la $PSD_{souhaitée}$ n'est pas définie à partir d'une équation dans laquelle $\alpha$ est le facteur de rugosité, $\xi$ est la longueur de corrélation, $\sigma$ est la déviation standard, N est le nombre de points, $\Delta y$ est l'écart entre les points et kn est le nombre d'onde. De manière plus générale, selon un exemple la $PSD_{souhaitée}$ n'est pas définie à partir d'une équation ou d'un modèle mathématique.

Selon un exemple la $PSD_{souhaitée}$ ne présente pas un profil comprenant successivement, et de préférence uniquement : un plateau, puis une cassure, puis une pente décroissante.

Selon un exemple la $PSD_{souhaitée}$ est tracée arbitrairement, c'est-à-dire sans respecter une équation ou un modèle mathématique.

De manière facultative, ce procédé de test des performances des conditions de mesure de rugosité d'un contour d'un motif peut présenter au moins l'une quelconque des caractéristiques suivantes prises séparément ou en combinaison :
Selon un exemple, le procédé comprend en outre une étape consistant à comparer $PSD_{test1}$ et $PSD_{souhaitée}$ et de préférence à calculer $\Delta = PSD_{test1} - PSD_{souhaitée}$.

Selon un exemple, on effectue au moins une fois la séquence suivante d'étapes :

- effectuer une mesure M1', avec des conditions de mesure E2' différentes de E2 et E1, de la rugosité du motif étalon fabriqué,
- sur la base de la mesure M1', calculer la densité spectrale de puissance $PSD_{test1}$' de la rugosité du motif étalon fabriqué,
- comparer $PSD_{test1'}$ et $PSD_{souhaitée}$.

Ainsi, en adaptant les conditions de mesure puis en réitérant cette séquence d'étapes, jusqu'à obtenir $\Delta = PSD_{test1'} - PSD_{souhaitée} = 0$ ou $\Delta \leq$ Seuil prédéterminé, il est possible de calibrer un équipement de mesure ou plus généralement des conditions de mesure.

Un autre aspect concerne un procédé de fabrication des performances des conditions de fabrication d'un motif. Ce procédé comprend les étapes suivantes :

- fabriquer un étalon de rugosité de contour en effectuant les étapes suivantes :
  - définir une densité spectrale de puissance souhaitée $PSD_{souhaitée}$ pour la rugosité d'un contour d'au moins un motif donné,
  - fabriquer au moins un motif de référence à partir d'un dessin de référence de l'au motif donné et avec des conditions données de fabrication $F_{référence}$, le dessin de référence présentant une rugosité nulle,
  - effectuer une mesure $M_{référence}$, avec des conditions de mesure $E_{référence}$, de la rugosité du motif de référence fabriqué,
  - sur la base de la mesure $M_{référence}$, calculer la densité spectrale de puissance $PSD_{référence}$ de la rugosité du motif de référence fabriqué ;
  - calculer une densité spectrale de puissance corrigée $PSD_{corrigée}$ telle que $PSD_{corrigée} = PSD_{souhaitée} - PSD_{référence}$,
  - définir un dessin corrigé présentant une rugosité respectant la $PSD_{corrigée}$,
  - fabriquer au moins un motif étalon à partir dudit dessin corrigé et avec lesdites conditions données de fabrication $F_{référence}$,
  - fabriquer au moins un motif test à partir dudit dessin corrigé et avec des conditions de fabrication F2 différentes des conditions données de fabrication $F_{référence}$,
  - effectuer une mesure M2, avec les conditions de mesure $E_{référence}$, dela rugosité du motif test fabriqué avec les conditions de fabrication F2,
  - sur la base de la mesure M2, calculer la densité spectrale de puissance $PSD_{test2}$ de la rugosité du motif test fabriqué avec les conditions de fabrication F2,
  - comparer PSDtest2 et $PSD_{souhaitée}$.

Cela permet de tester, comparer ou calibrer des conditions de fabrication.

Par exemple, il est alors également possible de modifier les conditions F2 afin d'amener un équipement de fabrication à générer la rugosité correspondant à une $PSD_{souhaitée}$.

De manière particulièrement avantageuse, cela permet également d'homogénéiser les paramètres de rugosité induits par un parc d'équipements. Typiquement, si un premier équipement d'un parc d'équipements induit une rugosité inférieure aux autres équipements du même parc, il est possible de ramener ce premier équipement au niveau du reste du parc. Ainsi, les dispositifs et motifs produits par l'ensemble des équipements du parc présenteront les mêmes paramètres en termes de rugosité. On peut ainsi réaliser des rugosités de ligne fonctionnelles. Dans ce cas, la rugosité peut, par exemple, permettre de changer l'énergie de surface et donc les forces de liaison à l'interface entre deux pièces en contact.

De manière facultative, ce procédé de test des performances des conditions de fabrication d'un motif peut présenter au moins l'une quelconque des caractéristiques suivantes prises séparément ou en combinaison :
Selon un exemple, les conditions de fabrication F2 diffèrent des conditions de fabrication $F_{référence}$ par au moins l'un des paramètres suivants :

- équipement de fabrication utilisé,
- paramétrage d'un équipement donné,
- matériaux composants le motif,
- solution de gravure utilisée.

On peut également effectuer une étape consistant à comparer $PSD_{test2}$ et $PSD_{souhaitée}$ et à calculer $\Delta = PSD_{test2} - PSD_{souhaitée}$.

Selon un exemple, on effectue au moins une fois la séquence suivante d'étapes :

- modifier les conditions de fabrication F2' telles que F2 et F2' soient différentes puis,
- effectuer une mesure M2', avec les conditions de mesure $E_{référence}$, de la rugosité du motif test fabriqué,
- sur la base de la mesure M2', calculer la densité spectrale de puissance $PSD_{test2'}$ de la rugosité du motif test fabriqué,
- comparer $PSD_{test2'}$ et $PSD_{souhaitée}$.

Un autre aspect concerne un produit programme d'ordinateur, de préférence enregistré sur un support non transitoire, comprenant des instructions, qui lorsqu'elles sont effectuées par au moins l'un parmi un processeur et un ordinateur, font que l'au moins un parmi le processeur et l'ordinateur exécute au moins les étapes suivantes du procédé selon l'invention :

- à partir de données relatives à un contour d'au moins un motif donné, définir une densité spectrale de puissance souhaitée $PSD_{souhaitée}$ pour la rugosité du contour du motif donné.
- sur la base de la mesure $M_{référence}$, calculer la densité spectrale de puissance $PSD_{référence}$ de la rugosité du motif de référence fabriqué. Au cours de cette étape, le programme reçoit des données relatives à la mesure $M_{référence}$. Ces données sont par exemple envoyées par un équipement de mesure qui effectue la mesure $M_{référence}$.
- calculer une densité spectrale de puissance corrigée $PSD_{corrigée}$ telle que $PSD_{corrigée} = PSD_{souhaitée} - PSD_{référence}$,
- définir un dessin corrigé présentant une rugosité respectant la $PSD_{corrigée}$,
- fournir le dessin corrigé à un équipement de fabrication.

Un autre aspect concerne un équipement de fabrication de motifs de taille micrométrique ou nanométrique, configuré pour effectuer les étapes suivantes :

- optionnellement, recevoir les caractéristiques géométriques d'un contour d'au moins un motif donné,
- recevoir les informations relatives à une densité spectrale de puissance souhaitée $PSD_{souhaitée}$ pour la rugosité d'un contour d'au moins un motif donné,
- fabriquer au moins un motif de référence à partir d'un dessin de référence de l'au motif donné, le dessin de référence présentant une rugosité nulle et avec des conditions données de fabrication,
- effectuer une mesure $M_{référence}$, avec des conditions de mesure E1, de la rugosité du motif de référence fabriqué,
- sur la base de la mesure $M_{référence}$, calculer la densité spectrale de puissance $PSD_{référence}$ de la rugosité du motif de référence fabriqué;
- calculer une densité spectrale de puissance corrigée $PSD_{corrigée}$ telle que $PSD_{corrigée} - PSD_{souhaitée} - PSD_{référence}$,
- définir un dessin corrigé présentant une rugosité respectant la $PSD_{corrigée}$,
- fabriquer au moins un motif étalon à partir dudit dessin corrigé et avec lesdites conditions données de fabrication $F_{référence}$.

## BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente de manière schématique et en perspective un réseau de motifs, ici de lignes droites.
La figure 2 représente en vue du dessus le réseau de la figure 1 dans un cas idéal, c'est-à-dire sans rugosité de ligne.
La figure 3 représente de manière schématique, en vue du dessus le réseau de la figure 1, avec une rugosité de ligne non nulle.
La figure 4 est une illustration d'un exemple de densité spectrale de puissance (PSD) pour une rugosité de ligne.
La figure 5 est un exemple de dessin d'un motif présentant une rugosité, ce dessin respectant la distribution induite par une PSD.
La figure 6 illustre les étapes d'une première méthode connue pour réaliser des motifs.
La figure 7 illustre les étapes d'une deuxième méthode connue pour réaliser des motifs.
La figure 8 illustre les étapes principales d'un exemple de procédé selon l'invention.
Les figures 9A à 9C illustrent sous forme de PSD quelques étapes d'un exemple de procédé selon l'invention.
La figure 10 est un graphe illustrant une PSD souhaitée et une PSD effectivement obtenue en mettant en oeuvre un procédé selon l'invention.
La figure 11 est un graphe correspondant à celui de la figure 9A mais pour lequel la PSD souhaitée est définie arbitrairement.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions respectives des motifs et des rugosités illustrées ne sont pas représentatives de la réalité.

## DESCRIPTION DÉTAILLÉE DE L'INVENTION

On entend par dispositif ou motif de taille micrométrique un dispositif ou un motif dont la dimension critique est inférieure à quelques centaines de micromètres, typiquement inférieure à 1 mm ($10^{-3}$ mètres), de préférence inférieure

à 500 $\mu$m ($10^{-6}$ mètres) et de préférence inférieure à 100 $\mu$m.

On entend par dispositif ou motif de taille nanométrique un dispositif ou un motif dont la dimension critique est inférieure à quelques centaines de nanomètres, typiquement inférieure à 1 $\mu$m ($10^{-6}$ mètres), de préférence inférieure à 500 nm ($10^{-9}$ mètres) et de préférence inférieure à 100 nm.

Dans le cadre de la présente invention, on entend par contour d'un motif la courbe, comprise dans un plan parallèle à un plan d'une face d'un substrat supportant le motif, obtenue en longeant le motif ou en en faisant le tour. La courbe correspond ainsi à une partie au moins d'une interface entre l'intérieur et l'extérieur du motif. Dans le cas d'un motif en ligne, le contour forme un rectangle ou une ligne si la définition du contour est effectuée sur un flanc seulement de la ligne. Dans le cas d'un motif formant un plot ou un pylône, le contour forme une courbe correspondant à la périphérie externe du motif en section selon ledit plan parallèle. Dans le cas d'un motif formant un trou ou un creux, le contour forme une courbe correspondant à la périphérie interne du motif en section selon ledit plan parallèle.

Dans le cadre de la présente invention, on entend par dimension critique la plus petite dimension que l'on cherche à contrôler. Dans le cas d'un motif en ligne la dimension critique peut être la largeur de la ligne, c'est-à-dire la dimension de la ligne selon une direction transverse, la direction transverse étant une direction perpendiculaire à la direction principale d'extension de la ligne et parallèle au plan principal d'une face du substrat supportant la ligne. Dans le cas d'une ligne, cette dimension critique est notée $CD_{largeur}$ en figure 2. La dimension critique peut également être l'espace entre deux lignes consécutives, prises selon ladite direction transverse. Dans le cas d'une ligne, cette dimension critique est notée $CD_{espace}$ en figure 2. La dimension critique peut encore être le pas d'un réseau formé d'une pluralité de lignes. Dans le cas d'une ligne, ce pas est noté Pitch en figure 2.

Si la ligne est courbe, la direction transverse sera prise perpendiculairement à la tangente au point considéré.

Si le motif est un plot ou un pylône la dimension critique sera par exemple la plus grande dimension de la section du pylône prise selon un plan parallèle au plan principal d'extension du substrat supportant le motif. Il en est de même si le motif est un trou. S'il motif présente un contour circulaire ou elliptique, la dimension critique sera respectivement le diamètre du cercle ou la plus grande longueur de l'ellipse.

Dans le cadre de la présente invention, le terme dessin désigne par exemple une information qui représente visuellement ou qui permet de représenter visuellement les fluctuations d'un contour respectant une PSD. Ces fluctuations respectent la distribution induite par la PSD. Un dessin peut également comprendre des informations ou des instructions aptes à être fournies à un équipement de fabrication d'un motif et qui permettent à cet équipement de fabriquer un motif en essayant de respecter la PSD. À partir d'un dessin on peut recalculer une PSD. À l'inverse, à partir d'une PSD on peut obtenir un dessin ou plusieurs dessins, habituellement appelés « layout » en anglais.

Le terme « étape » ne signifie pas obligatoirement que les actions menées soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Dans le cadre de la présente invention, on qualifie de résine un matériau organique ou organo-minéral pouvant être mis en forme par une exposition à un faisceau d'électrons, de photons ou de rayons X ou mécaniquement. On peut citer à titre d'exemple des résines classiquement employées en microélectronique, des résines à base de polystyrène (PS), de méthacrylate (par exemple le Polymethyl methacrylate PMMA), d'Hydrosilsesquioxane (HSQ), de polyhydroxystyrène (PHS) etc.

En référence aux figures 8 à 10, un exemple de procédé selon l'invention va maintenant être décrit.

La figure 8 illustre certaines des étapes pour réaliser un motif étalon. Comme illustré sur cette figure, au cours d'une étape préliminaire 19 on définit les caractéristiques géométriques d'un contour d'au moins une forme géométrique formant au moins un motif donné, également désigné motif de base. On peut choisir ou recevoir ce motif. Ce motif peut définir une courbe rectiligne ou non. Il peut définir une pluralité de courbes. Ces courbes peuvent être agencées de manière périodique ou non. Elles peuvent par exemple former un réseau tel que celui illustré en figure 1 à 3. Alternativement, le motif peut définir un plot ou un pylône. Le motif peut également définir un trou. La ou les courbes peuvent être entièrement fermées ou fermées sur une portion seulement de leur longueur. Ce motif de base est par exemple défini par une forme (ligne, courbe, pylône etc.), des dimensions, un pas etc.

Comme illustré par l'étape 10 de la figure 8, on définit une densité spectrale de puissance souhaitée $PSD_{souhaitée}$ pour la rugosité du contour du ou des motifs que l'on souhaite fabriquer. Cette $PSD_{souhaitée}$ peut être déterminée indépendamment du motif donné. Elle peut par exemple être tracée sur un graphe tel que celui illustré en figure 9A ou 10. Sur ces graphes, la $PSD_{souhaitée}$ est référencée 100.

De manière non limitative, la $PSD_{souhaitée}$ peut être définie en fonction de paramètres tels que les paramètres suivants : $\alpha$ le facteur de rugosité, $\xi$ la longueur de corrélation, $\sigma$ la déviation standard, N le nombre de point, $\Delta y$ l'écart entre les points et kn le nombre d'onde.

Si le contour est une ligne rectiligne, cette $PSD_{souhaitée}$ peut définir ou conditionner la rugosité de largeur de ligne, habituellement désignée par son acronyme anglais LWR (Line Width Roughness). Cette $PSD_{souhaitée}$ peut alternativement définir ou conditionner la rugosité de bord de ligne, habituellement désignée par son acronyme anglais LER (Line Edge Roughness).

Comme illustré par l'étape 20 de la figure 8, après, simultanément ou avant la définition de la $PSD_{souhaitée}$, on définit ou on reçoit un dessin sans rugosité correspondant au motif donné. Sur ce dessin, la rugosité du contour est nulle. Il s'agit ainsi d'un dessin idéal qui ne présente aucune rugosité programmée. Ce motif et donc le dessin sont par exemple caractérisés par une forme (ligne, courbe, pylône etc.) et des dimensions.

Typiquement, si le motif est une ligne ou un réseau de lignes, le bord des lignes ne présente aucune fluctuation.

On fabrique ensuite un motif de référence à partir du dessin de référence. Cette fabrication est effectuée avec des conditions données de fabrication. Ces conditions données de fabrication sont notées $F_{référence}$. À titre d'exemple uniquement, et de manière non exhaustive, parmi les conditions de fabrication $F_{référence}$ on peut citer :

- le type d'équipement de fabrication, (par exemple équipement de photolithographie ou d'impression nanométrique),
- l'équipement de fabrication lui-même parmi un type d'équipement,
- les matériaux utilisés pour former le motif. Par exemple la nature de la résine si le motif à réaliser est en résine.
- les conditions du procédé de fabrication. Il peut par exemple s'agir des conditions d'exposition si la résine est exposée à un flux lumineux ou un flux d'électrons. De manière additionnelle ou alternative, il peut s'agir de conditions de gravure (chimie de gravure, durée de gravure etc.).

Comme illustré par l'étape 21 on mesure $M_{référence}$ la rugosité du motif de référence fabriqué avec les conditions fabrication $F_{référence}$ en ayant pour consigne de reproduire le dessin sans rugosité. Cette mesure $M_{référence}$ est effectuée dans des conditions de mesure $E_{référence}$. À titre d'exemple uniquement, et de manière non exhaustive, parmi les conditions de mesure $E_{référence}$ on peut citer :

- le type d'équipement de mesure,
- l'équipement de mesure lui-même parmi un type d'équipement,
- les conditions du procédé de mesure. À titre d'exemple on peut citer par exemple : la fréquence d'échantillonnage, la vitesse de mesure, la longueur mesurée du contour etc.

Sur la base de la mesure $M_{référence}$, on calcule ensuite la densité spectrale de puissance $PSD_{référence}$ de la rugosité du motif de référence fabriqué (étape 22). Cette $PSD_{référence}$ peut être illustrée sous forme d'une courbe référencée 200 en figure 9A. On pourra par exemple se référer à la publication mentionnée en section relative à l'état de la technique pour calculer une PSD à partir de mesures de rugosité.

Comme illustré par l'étape 30, de la définition de la rugosité souhaitée $PSD_{souhaitée}$ est soustraite la rugosité de référence $PSD_{référence}$. On définit ainsi une densité spectrale de puissance corrigée $PSD_{corrigée}$ telle que $PSD_{corrigée} = PSD_{souhaitée} - PSD_{référence}$.

Cette $PSD_{corrigée}$ est illustré sous forme d'une courbe référencée 300 en figure 9A.

Sur la base de cette $PSD_{corrigée}$ on génère ensuite un dessin, désigné dessin corrigé. Ainsi, ce dessin corrigé présente une rugosité respectant la $PSD_{corrigée}$. Typiquement, ce dessin est généré au travers d'une loi aléatoire et d'une transformée de fourrier inverse. On pourra par exemple se référer aux publications mentionnées en section relative à l'état de la technique pour générer un dessin à partir d'une PSD et en particulier à la publication suivante.

Une étape suivante (étape 50) consiste à fabriquer au moins un motif à partir du dessin corrigé. Ce motif est désigné motif étalon. Pour cela, on applique les conditions de fabrication $F_{référence}$.

Lors de ce procédé de fabrication, les conditions étant identiques à celles utilisées pour fabriquer le motif de référence, la rugosité naturelle induite par ces conditions vient impactée le dessin. Cette rugosité naturelle s'ajoute donc statistiquement au dessin corrigé. Cette addition peut être représentée par la somme de la courbe 200 illustrant la $PSD_{référence}$ induite par la rugosité naturelle et de la courbe 300 illustrant la $PSD_{corrigée}$ induite par la rugosité du dessin corrigé. La somme de ces deux courbes est illustrée en figure 9B. Le résultat de cette somme est illustré par la courbe de la figure 9C et correspond à la $PSD_{scuhaitée}$. Ainsi, on obtient au final la signature de rugosité que l'on souhaitait.

La figure 10 est un graphe faisant apparaître clairement la correspondance entre une PSD souhaitée $PSD_{souhaitée}$ 100 est une PSD réelle, obtenue par mesure du motif étalon fabriqué. Comme indiqué ci-dessus, la $PSD_{souhaitée}$ 100 peut être tracée arbitrairement. Elle correspond donc à la PSD programmée à l'étape 10 illustrée en figure 8. La figure 10 fait également apparaître sous forme de valeurs ponctuelles la PSD réelle, c'est-à-dire la PSD calculée sur la base des mesures de rugosité réalisées, avec les conditions de mesure $E_{référence}$, sur l'échantillon étalon fabriqué. Il ressort clairement de ce graphe que la PSD issue des mesures correspond très étroitement à la PSD souhaitée 100. La PSD de la figure 10 été obtenue à partir d'une image présentant une longueur de 2,4$\mu$m ($10^{-6}$ mètres) avec une taille de pixel de 2,75 nm ($10^{-9}$ mètres).

Comme indiqué ci-dessus, la $PSD_{souhaitée}$ 100 peut être tracée arbitrairement. Ainsi, selon un exemple la $PSD_{souhaitée}$ 100 n'est pas définie à partir d'un modèle mathématique ou d'une équation notamment d'une équation comprenant au moins deux des paramètres suivants : $\alpha$ (facteur de rugosité), $\xi$ (longueur de corrélation), $\sigma$ (déviation

standard), N (nombre de points), Δy (écart entre les points) et kn (nombre d'onde). La figure 11 illustre un exemple non limitatif de $PSD_{souhaitée}$ tracée librement. Par exemple la $PSD_{souhaitée}$ ne présente pas un profil comprenant successivement et uniquement un plateau, puis une cassure, puis une pente décroissante. Dans l'exemple de la figure 11, la $PSD_{souhaitée}$ 100 présente un plateau, puis une cassure, puis une pente croissante, puis une cassure, puis un plateau, puis une cassure, puis une pente décroissante puis à nouveau une cassure puis un plateau. Il s'ensuit que la $PSD_{corrigée}$ 200 présente successivement : plateau-cassure-pente croissante-cassure-plateau-cassure-pente croissante-cassure-pente décroissante-cassure.

Le fait de définir une PSD de manière arbitraire ou libre, c'est-à-dire sans nécessairement respecter un modèle mathématique ou une équation, permet par exemple d'avoir une rugosité souhaitée, par exemple une forte rugosité, dans les fréquences souhaitées (hautes ou basses par exemple). Cela permet alors de fonctionnaliser la rugosité. Des exemples de fonctionnalisation de la rugosité seront décrits par la suite.

Les étapes 60 et 70 de la figure 8 illustrent cette démarche consistant à mesurer la rugosité du motif étalon fabriqué puis à vérifier que la PSD de cet étalon fabriqué correspond à la PSD souhaitée. Naturellement, la distribution de rugosité obtenue au final n'est pas inférieure à la distribution de rugosité naturelle induite par le procédé de fabrication. Cette dernière n'est pas corrigée mais elle est prise statistiquement en compte dans le dessin de consigne servant à la fabrication.

Le procédé décrit ci-dessus permet ainsi d'obtenir un motif étalon présentant une signature de rugosité désirée.

À partir de ce motif étalon, dont les paramètres de rugosité sont connus on peut procéder à de nombreux tests, comparaisons et calibrations.

Par exemple, il est possible de tester, comparer ou calibrer des conditions de mesure. Un exemple de procédé est décrit par les étapes 80 et 90 de la figure 8.

Comme illustré par l'étape 80, on peut effectuer une mesure M1 de la rugosité du motif étalon avec des conditions de mesure E1 différentes des conditions de mesure $E_{référence}$. On peut par exemple changer l'équipement de mesure ou les paramètres du procédé de mesure telle que la vitesse de mesure, la fréquence d'échantillonnage, la longueur mesurée, le nombre de contours mesurés etc.

Sur la base de cette mesure M1, on calcule la densité spectrale de puissance $PSD_{test1}$ de la rugosité du motif étalon fabriqué. Il est alors possible de comparer $PSD_{test1}$ et la $PSD_{souhaitée}$. Par exemple $\Delta = PSD_{test1} - PSD_{souhaitée}$. Si Δ est nulle ou est proche de zéro, alors les conditions de mesure E1 sont aussi performantes que les conditions de mesure $E_{référence}$. Si Δ est supérieur à un seuil, alors il est possible de déterminer si les conditions de mesure E1 sont supérieures ou inférieures aux conditions de mesure $E_{référence}$ en termes de performances.

Ce procédé permet ainsi de manière particulièrement efficace de comparer les conditions de mesure afin de les améliorer ou tout au moins de les rendre homogènes. Par ailleurs, il est également possible de calibrer un équipement de mesure donnée pour l'amener à une distribution souhaitée par exemple identique à d'autres équipements. Ainsi, si l'on souhaite modifier les conditions de mesure E1 pour que ces conditions de mesure donnent des résultats de mesure identiques aux conditions de mesure $E_{référence}$, on peut procéder à plusieurs itérations des étapes 80 et 90 en modifiant à chaque fois les conditions E1, jusqu'à atteindre un Δ nulle ou inférieur à un seuil que l'on se sera fixé.

Une autre application particulièrement avantageuse du procédé décrit ci-dessus consiste à tester, comparer ou calibrer des conditions de fabrication.

Ainsi, on peut fabriquer un motif test en mettant en œuvre des conditions de fabrication F2 différentes des conditions de fabrication $F_{référence}$. On effectue ensuite, en appliquant les conditions de mesure $E_{référence}$, une mesure M2 du motif test. Sur la base de la mesure M2, on calcule la densité spectrale de puissance $PSD_{test2}$ de la rugosité du motif test. On comparer ensuite $PSD_{test2}$ et $PSD_{souhaitée}$. Il est possible de calculer Δ tel que $\Delta = PSD_{test2} - PSD_{souhaitée}$.

On peut alors comparer les performances des conditions de fabrication F2 et $F_{référence}$. Il est alors possible d'améliorer les conditions de fabrication ou de les modifier pour les rendre homogènes ou conformes à une consigne que l'on se fixe.

La qualité de la programmation de la rugosité est notamment liée aux paramètres suivants :

- la caractérisation de la référence en termes de : résolution, échantillonnage, plage de fréquence, la plage de fréquence correspondant à la différence entre la plus basse fréquence atteignable (liée à la longueur de mesure) et la plus haute fréquence (liée elle à l'échantillonnage),
- la stabilité des procédés utilisés, c'est-à-dire la capacité à appliquer les mêmes conditions de fabrication $F_{référence}$ lors de la fabrication du motif de référence et lors de la fabrication du motif final (motif étalon).
- les fidélités de réalisation des dessins par les équipements.

De manière avantageuse, le procédé décrit ci-dessus permet de contrôler la LER (rugosité de déplacement de la ligne) et la LWR (rugosité de taille de la ligne).

Au vu de la description qui précède il apparaît clairement que le procédé décrit offre des avantages significatifs en termes de création d'étalons de rugosité, de calibration d'équipements, de test des capacités de techniques et d'équipements ou encore du développement de nouvelles méthodes de mesures.

Par ailleurs, le procédé décrit permet d'homogénéiser et de stabiliser les performances des procédés en pouvant réaliser les mêmes types de rugosité quel que soit l'équipement. Le procédé décrit permet alors de rendre fonctionnelle la rugosité de ligne ou plus généralement la rugosité de contour. La rugosité peut par exemple permettre de changer l'énergie de surface et donc les forces de liaison à l'interface entre deux pièces destinées à être en contact. La fonctionnalisation de la rugosité peut conférer des avantages considérables dans de nombreuses autres applications. Par exemple, en microfluidique, on peut prévoir d'adapter la $PSD_{souhaitée}$ aux paramètres d'un fluide, par exemple en l'augmentant en fonction de la viscosité du fluide, afin de diminuer la vitesse d'écoulement d'un fluide dans un conduit ou dans une cavité.

L'invention n'est pas limitée aux modes de réalisations précédemment décrits et s'étend à tous les modes de réalisation couverts par les revendications.

## Revendications

1. Procédé de fabrication d'un étalon de rugosité de contour comprenant les étapes suivantes :

   - définir (10) une densité spectrale de puissance souhaitée $PSD_{souhaitée}$ d'une rugosité d'un contour,
   - fabriquer (20), avec des conditions données de fabrication $F_{référence}$, un motif de référence à partir d'un dessin de référence d'un motif donné, le dessin de référence présentant une rugosité nulle,
   - effectuer une mesure (21) $M_{référence}$ de la rugosité du motif de référence,
   - Sur la base de la mesure $M_{référence}$, calculer (22) la densité spectrale de puissance $PSD_{référence}$ de la rugosité du motif de référence fabriqué;
   - calculer (30) une densité spectrale de puissance corrigée $PSD_{corrigée}$ telle que $PSD_{corrigée} = PSD_{souhaitée} - PSD_{référence}$,
   - définir (40) un dessin corrigé présentant une rugosité respectant la $PSD_{corrigée}$,
   - fabriquer (50) un motif étalon à partir dudit dessin corrigé, et avec lesdites conditions données de fabrication $F_{référence}$.

2. Procédé selon la revendication précédente dans lequel la $PSD_{souhaitée}$ est définie de sorte que pour chaque fréquence ou nombre d'onde de la $PSD_{souhaitée}$ : $PSD_{souhaitée} \geq PSD_{référence}$.

3. Procédé selon l'une quelconque des revendications précédentes dans lequel le contour comprend au moins l'une parmi :

   - une ligne droite, l'au moins un motif donné formant par exemple un réseau de lignes parallèles,
   - une ligne courbe, et de préférence une ligne courbe dont une partie au moins est fermée l'au moins un motif donné formant par exemple au moins l'un parmi un trou, un plot et un pylône.

4. Procédé selon l'une quelconque des revendications précédentes dans lequel la $PSD_{souhaitée}$ n'est pas définie à partir d'une équation et/ou ne présente pas un profil comprenant successivement et uniquement un plateau, puis une cassure, puis une pente décroissante.

5. Procédé selon la revendication 1, dans laquelle l'étape de mesure (21) $M_{référence}$ de la rugosité du motif de référence est effectuée avec des conditions de mesure $E_{référence}$, le procédé comprenant en outre l'étape suivante :

   - effectuer une mesure M1 (80), avec des conditions de mesure E1 différentes des conditions de mesure de $E_{référence}$, de la rugosité du motif étalon fabriqué, et dans lequel les conditions de mesure E1 diffèrent des conditions de mesure de $E_{référence}$ de préférence par au moins l'un des paramètres suivants :
   - équipement de mesure utilisé,
   - fréquence d'échantillonnage,
   - longueur mesurée,
   - vitesse de mesure,
   - nombre de contours mesurés.

6. Procédé selon la revendication précédente comprenant en outre l'étape suivante :

   - sur la base de la mesure M1, calculer la densité spectrale de puissance $PSD_{test1}$ de la rugosité du motif étalon fabriqué,
- comparer $PSD_{test1}$ et $PSD_{souhaitée}$.

**7.** Procédé selon la revendication 1, dans laquelle l'étape de mesure (21) $M_{référence}$ de la rugosité du motif de référence est effectuée avec des conditions de mesure $E_{référence}$, le procédé comprenant en outre les étapes suivantes :

- fabriquer au moins un motif test à partir dudit dessin corrigé c'est-à-dire en prenant pour consigne ce dessin corrigé et avec des conditions de fabrication F2 différentes des conditions de fabrication $F_{référence}$,
- effectuer une mesure M2, avec les conditions de mesure $E_{référence}$ de la rugosité du motif test fabriqué avec les conditions de fabrication F2,
- sur la base de la mesure M2, calculer la densité spectrale de puissance $PSD_{test2}$ de la rugosité du motif test fabriqué avec les conditions de fabrication F2,
- comparer PSDtest2 et $PSD_{souhaitée}$.

**8.** Procédé de test des performances des conditions de mesure de rugosité de contour d'un motif comprenant les étapes suivantes :

- fabriquer un étalon de rugosité de contour en effectuant les étapes suivantes :

  • définir (10) une densité spectrale de puissance souhaitée $PSD_{souhaitée}$ pour la rugosité d'un contour d'au moins un motif donné,
  • fabriquer (20) au moins un motif de référence à partir d'un dessin de référence de l'au motif donné et avec des conditions données de fabrication $F_{référence}$, le dessin de référence présentant une rugosité nulle,
  • effectuer une mesure (21) $M_{référence}$ de la rugosité du motif de référence fabriqué avec des conditions de mesure $E_{référence}$,
  • sur la base de la mesure $M_{référence}$, calculer (22) la densité spectrale de puissance $PSD_{référence}$ de la rugosité du motif de référence fabriqué ;
  • calculer (30) une densité spectrale de puissance corrigée $PSD_{corrigée}$ telle que $PSD_{corrigée} = PSD_{souhaitée} - PSD_{référence}$,
  • définir (40) un dessin corrigé présentant une rugosité respectant la $PSD_{corrigée}$,
  • fabriquer (50) au moins un motif étalon à partir dudit dessin corrigé et avec lesdites conditions données de fabrication $F_{référence}$,

- effectuer une mesure (80) M1, avec des conditions de mesure E1 différentes de $E_{référence}$, de la rugosité du motif étalon fabriqué,
- sur la base de la mesure M1, calculer (90) la densité spectrale de puissance $PSD_{test1}$ de la rugosité du motif étalon fabriqué.

**9.** Procédé selon la revendication précédente comprenant en outre une étape consistant à comparer $PSD_{test1}$ et $PSD_{souhaitée}$ et de préférence à calculer $\Delta = PSD_{test1} - PSD_{souhaitée}$.

**10.** Procédé selon la revendication précédente dans lequel on effectue au moins une fois la séquence suivante d'étapes :

- effectuer une mesure (80) M1', avec des conditions de mesure E2' différentes de E2 et E1, de la rugosité du motif étalon fabriqué,
- sur la base de la mesure M1', calculer la densité spectrale de puissance $PSD_{test1}$' de la rugosité du motif étalon fabriqué,
- comparer $PSD_{test1'}$ et $PSD_{souhaitée}$.

**11.** Procédé de test des performances des conditions de fabrication d'un motif présentant un contour, le procédé comprenant les étapes suivantes :

- fabriquer un étalon de rugosité de contour en effectuant les étapes suivantes :

  • à partir des caractéristiques géométriques d'un contour d'au moins un motif donné, définir (10) une densité spectrale de puissance souhaitée $PSD_{souhaitée}$ pour la rugosité du contour de l'au moins un motif donné,
  • fabriquer (20) au moins un motif de référence à partir d'un dessin de référence de l'au motif donné et avec des conditions données de fabrication $F_{référence}$, le dessin de référence présentant une rugosité nulle,

• effectuer une mesure (21) $M_{référence}$ de la rugosité du motif de référence fabriqué avec des conditions de mesure $E_{référence}$,
• sur la base de la mesure $M_{référence}$, calculer (22) la densité spectrale de puissance $PSD_{référence}$ de la rugosité du motif de référence fabriqué ;
• calculer (30) une densité spectrale de puissance corrigée $PSD_{corrigée}$ telle que $PSD_{corrigée} = PSD_{souhaitée} - PSD_{référence}$,
• définir (40) un dessin corrigé présentant une rugosité respectant la $PSD_{corrigée}$,
• fabriquer (50) au moins un motif étalon à partir dudit dessin corrigé et avec lesdites conditions données de fabrication $F_{référence}$,

- fabriquer au moins un motif test à partir dudit dessin corrigé et avec des conditions de fabrication F2 différentes des conditions données de fabrication $F_{référence}$,
- effectuer une mesure M2, avec les conditions de mesure $E_{référence}$, de la rugosité du motif test fabriqué avec les conditions de fabrication F2,
- sur la base de la mesure M2, calculer la densité spectrale de puissance $PSD_{test2}$ de la rugosité du motif test fabriqué avec les conditions de fabrication F2,
- comparer PSDtest2 et $PSD_{souhaitée}$.

**12.** Procédé selon la revendication précédente dans lequel les conditions de fabrication F2 différent des conditions de fabrication $F_{référence}$ par au moins l'un des paramètres suivants :

- équipement de fabrication utilisé,
- paramétrage de l'équipement utilisé
- le ou les matériaux composants le motif de référence et le motif test,
- solution de gravure utilisée.

**13.** Procédé selon la revendication précédente dans lequel on effectue au moins une fois la séquence suivante d'étapes :

- modifier les conditions de fabrication F2' telles que F2 et F2' soient différentes puis,
- effectuer une mesure M2', avec les conditions de mesure $E_{référence}$, de la rugosité du motif test fabriqué,
- sur la base de la mesure M2', calculer la densité spectrale de puissance $PSD_{test2'}$ de la rugosité du motif test fabriqué,
- comparer $PSD_{test2'}$ et $PSD_{souhaitée}$.

**14.** Produit programme d'ordinateur, de préférence enregistré sur un support non transitoire, comprenant des instructions, qui lorsqu'elles sont effectuées par au moins l'un parmi un processeur et un ordinateur, font que l'au moins un parmi le processeur et l'ordinateur exécute au moins les étapes suivantes du procédé selon l'une quelconque des revendications précédentes :

- à partir d'un contour d'au moins un motif donné (1), définir une densité spectrale de puissance souhaitée $PSD_{souhaitée}$ pour la rugosité du contour du motif donné (1),
- sur la base de la mesure $M_{référence}$, calculer la densité spectrale de puissance $PSD_{référence}$ de la rugosité du motif de référence fabriqué;
- calculer une densité spectrale de puissance corrigée $PSD_{corrigée}$ telle que $PSD_{corrigée} = PSD_{souhaitée} - PSD_{référence}$,
- définir un dessin corrigé présentant une rugosité respectant la $PSD_{corrigée}$,
- fournir le dessin corrigé à un équipement de fabrication.

**15.** Equipement de fabrication de motifs de taille micrométrique ou nanométrique, configuré pour effectuer les étapes suivantes :

- recevoir les caractéristiques géométriques d'un contour d'au moins un motif donné,
- recevoir les informations relatives à une densité spectrale de puissance souhaitée $PSD_{souhaitée}$ pour la rugosité du contour de l'au moins un motif donné,
- fabriquer, avec des conditions données de fabrication $F_{référence}$, au moins un motif de référence à partir d'un dessin de référence de l'au motif donné, le dessin de référence présentant une rugosité nulle et avec des conditions données de fabrication,
- effectuer une mesure $M_{référence}$ de la rugosité du motif de référence fabriqué avec des conditions de mesure E1,

- sur la base de la mesure $M_{référence}$, calculer la densité spectrale de puissance $PSD_{référence}$ de la rugosité du motif de référence fabriqué;
- calculer une densité spectrale de puissance corrigée $PSD_{corrigée}$ telle que $PSD_{corrigée} = PSD_{souhaitée} - PSD_{référence}$,
- définir un dessin corrigé présentant une rugosité respectant la $PSD_{corrigée}$,
- fabriquer au moins un motif étalon à partir dudit dessin corrigé et avec lesdites conditions données de fabrication $F_{référence}$.

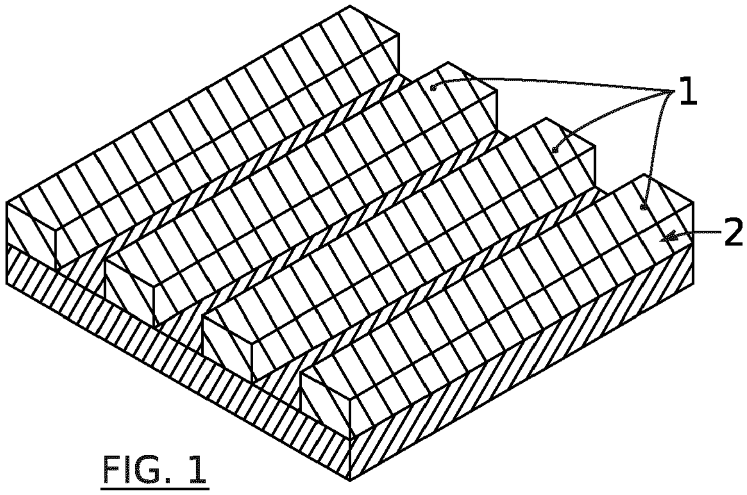


FIG. 1

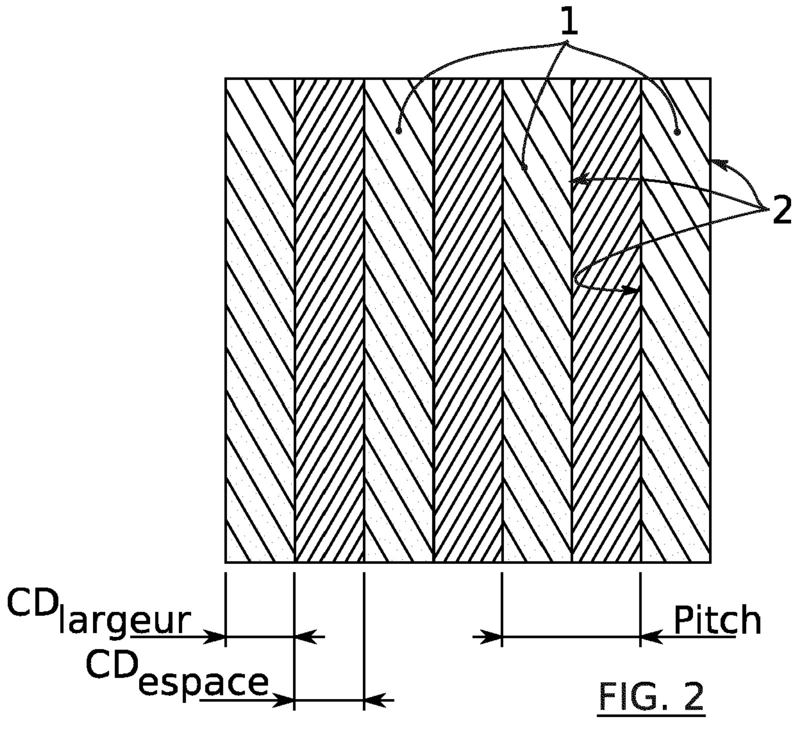


FIG. 2

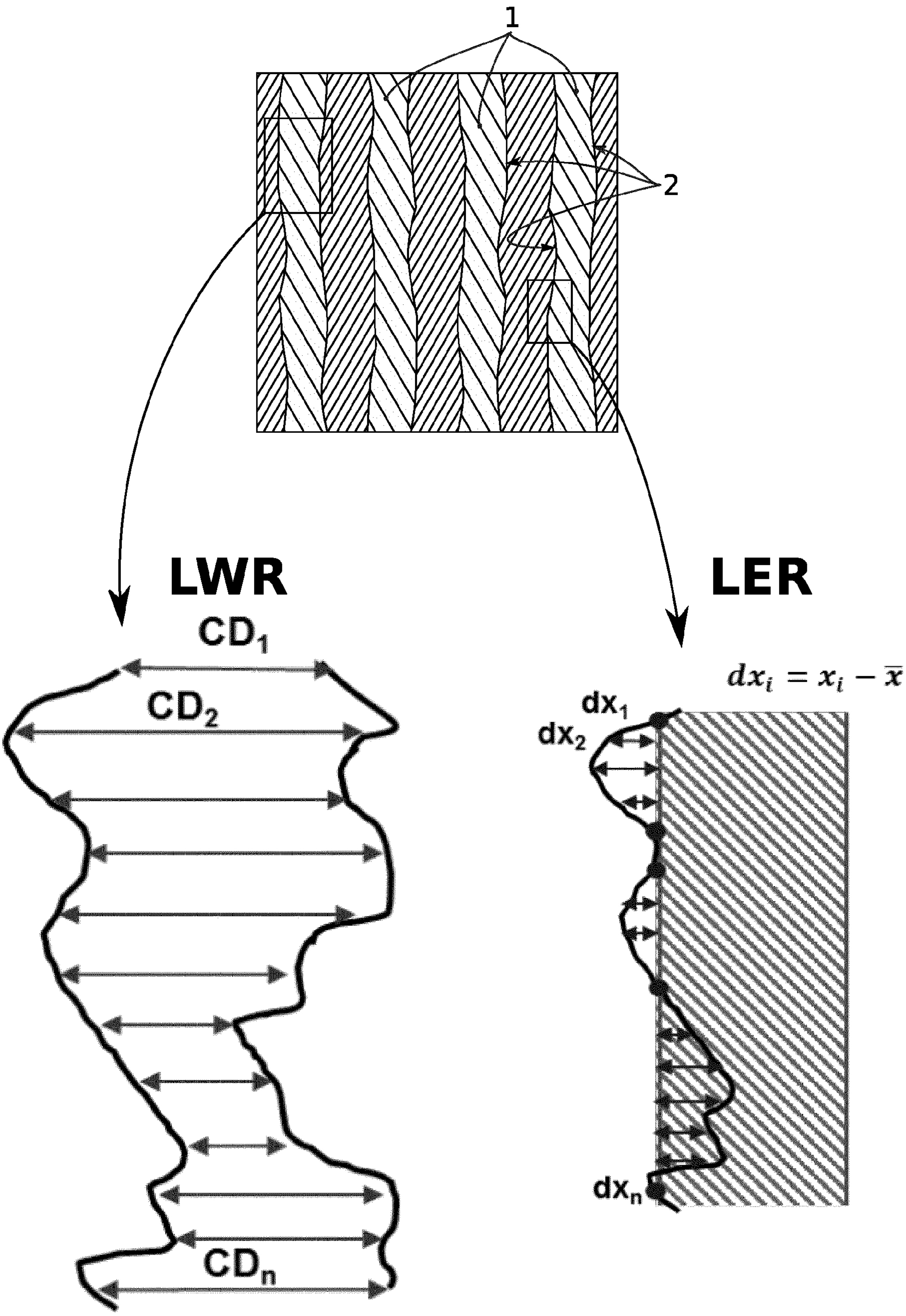


FIG. 3

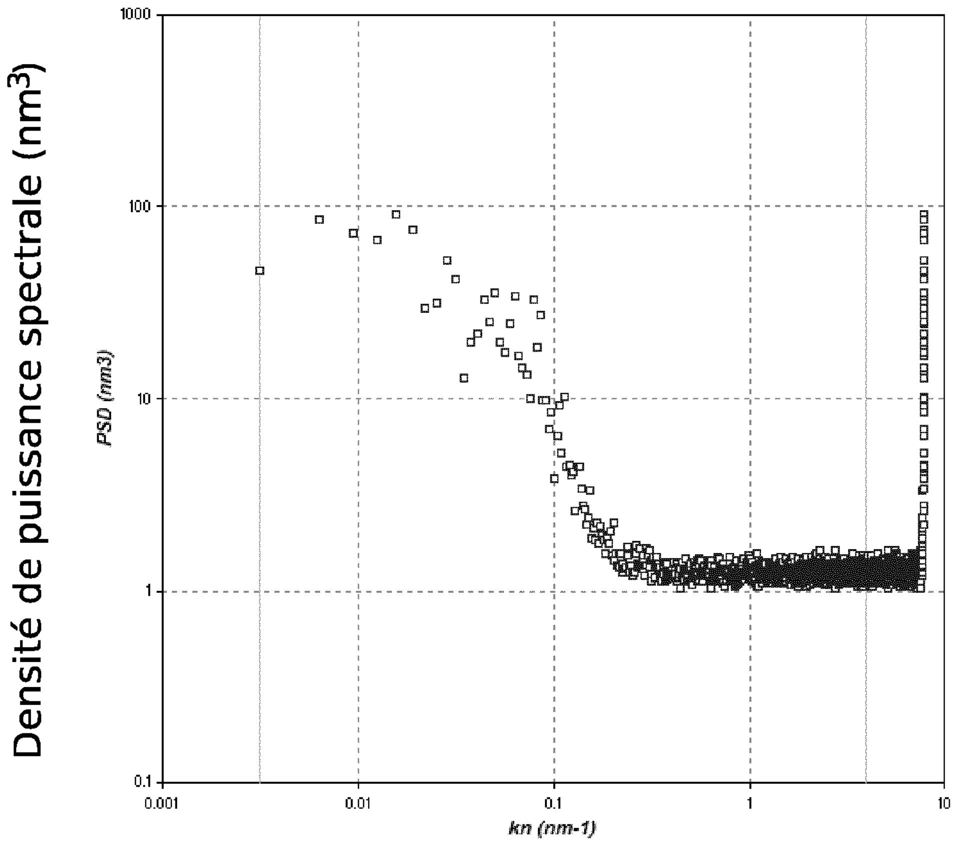
Densité de puissance spectrale (nm3)
PSD (nm3)
1000
100
10
1
0.1
0.001
0.01
0.1
1
10
kn (nm-1)

FIG. 4

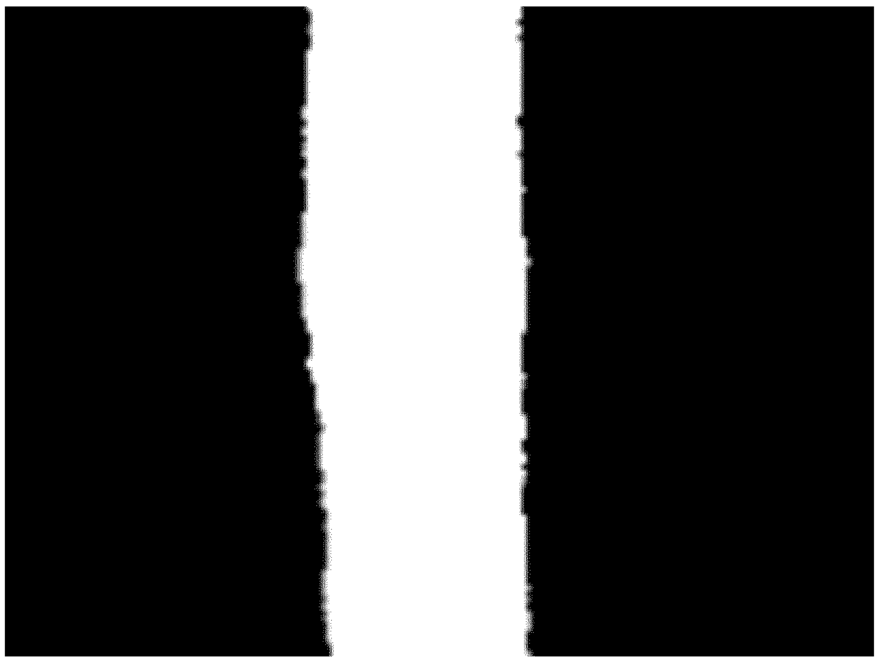

FIG. 5

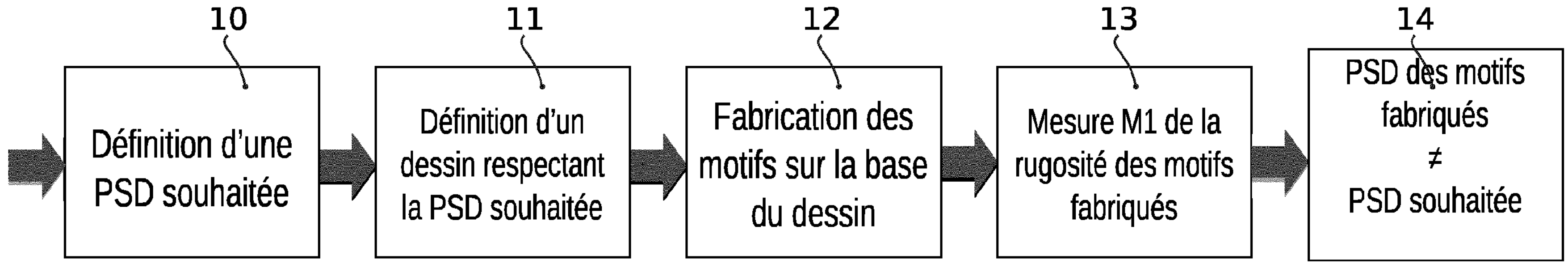
10
Définition d'une PSD souhaitée
11
Définition d'un dessin respectant la PSD souhaitée
12
Fabrication des motifs sur la base du dessin
13
Mesure M1 de la rugosité des motifs fabriqués
14
PSD des motifs fabriqués ≠ PSD souhaitée

FIG. 6

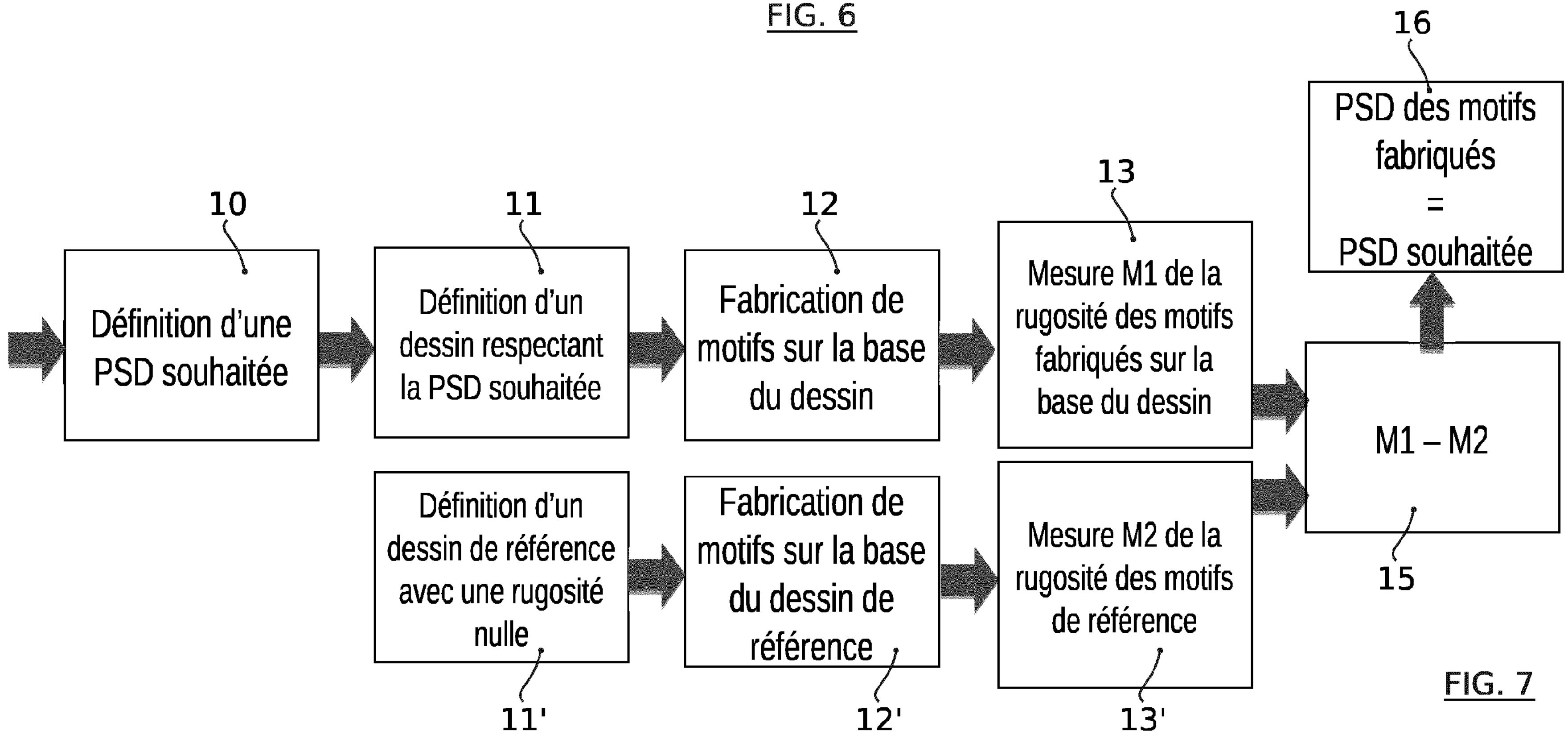
10
Définition d'une PSD souhaitée
11
Définition d'un dessin respectant la PSD souhaitée
12
Fabrication de motifs sur la base du dessin
13
Mesure M1 de la rugosité des motifs fabriqués sur la base du dessin
11'
Définition d'un dessin de référence avec une rugosité nulle
12'
Fabrication de motifs sur la base du dessin de référence
13'
Mesure M2 de la rugosité des motifs de référence
15
M1 – M2
16
PSD des motifs fabriqués = PSD souhaitée

FIG. 7

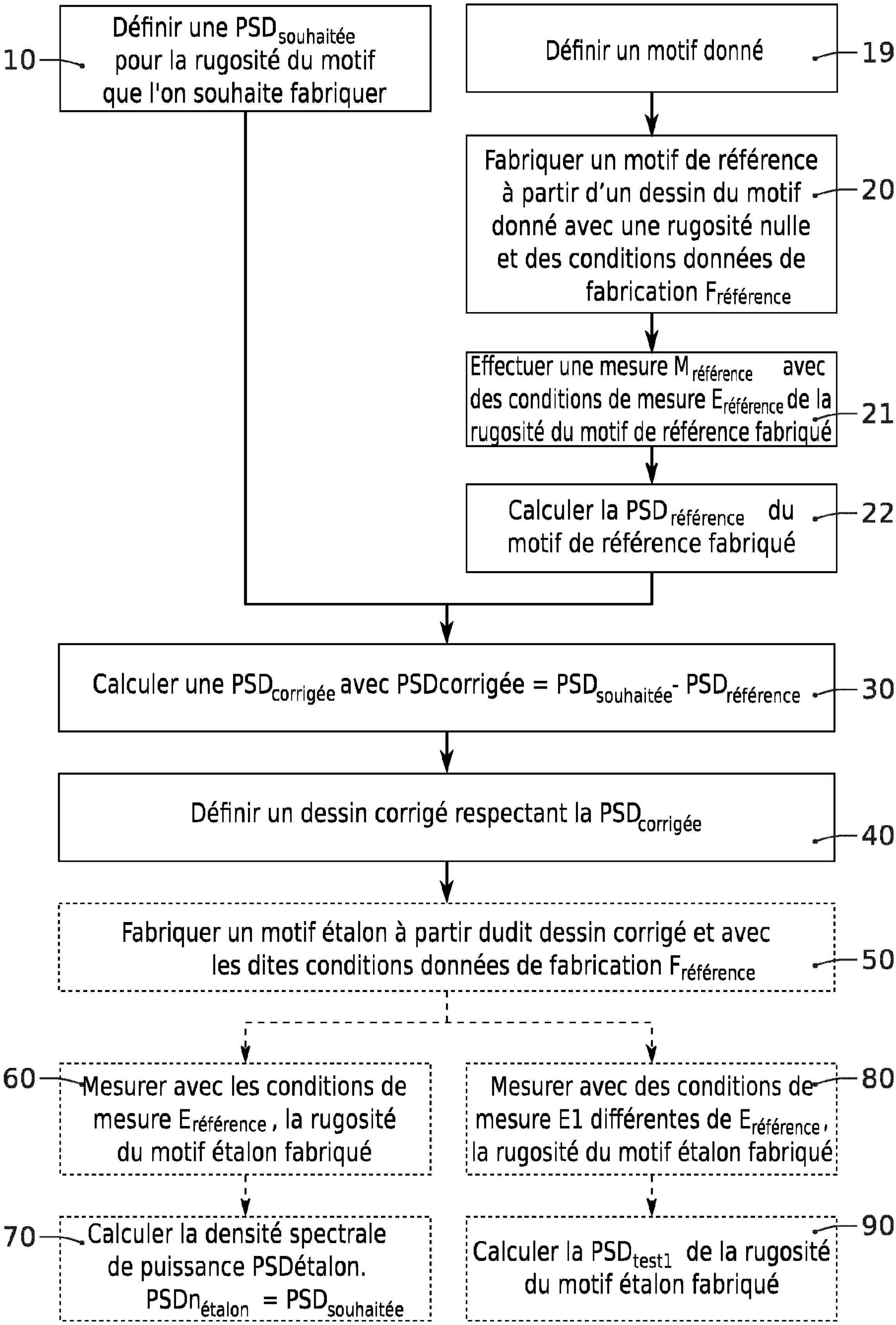

Définir une PSD souhaitée pour la rugosité du motif que l'on souhaite fabriquer
10
Définir un motif donné
19
Fabriquer un motif de référence à partir d'un dessin du motif donné avec une rugosité nulle et des conditions données de fabrication F référence
20
Effectuer une mesure M référence avec des conditions de mesure E référence de la rugosité du motif de référence fabriqué
21
Calculer la PSD référence du motif de référence fabriqué
22
Calculer une PSD corrigée avec PSDcorrigée = PSD souhaitée - PSD référence
30
Définir un dessin corrigé respectant la PSD corrigée
40
Fabriquer un motif étalon à partir dudit dessin corrigé et avec les dites conditions données de fabrication F référence
50
Mesurer avec les conditions de mesure E référence, la rugosité du motif étalon fabriqué
60
Mesurer avec des conditions de mesure E1 différentes de E référence, la rugosité du motif étalon fabriqué
80
Calculer la densité spectrale de puissance PSDétalon. PSDn étalon = PSD souhaitée
70
Calculer la PSD test1 de la rugosité du motif étalon fabriqué
90

FIG. 8

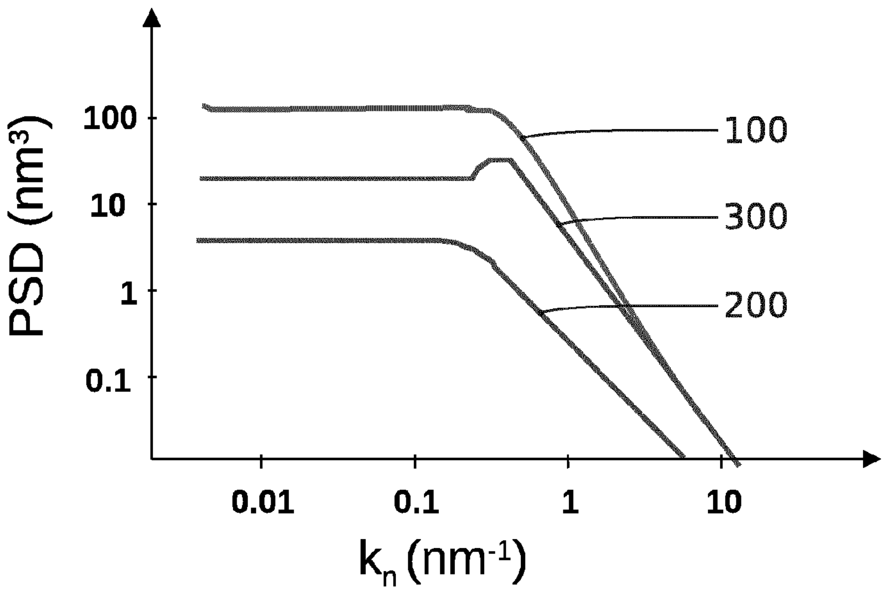


FIG. 9A

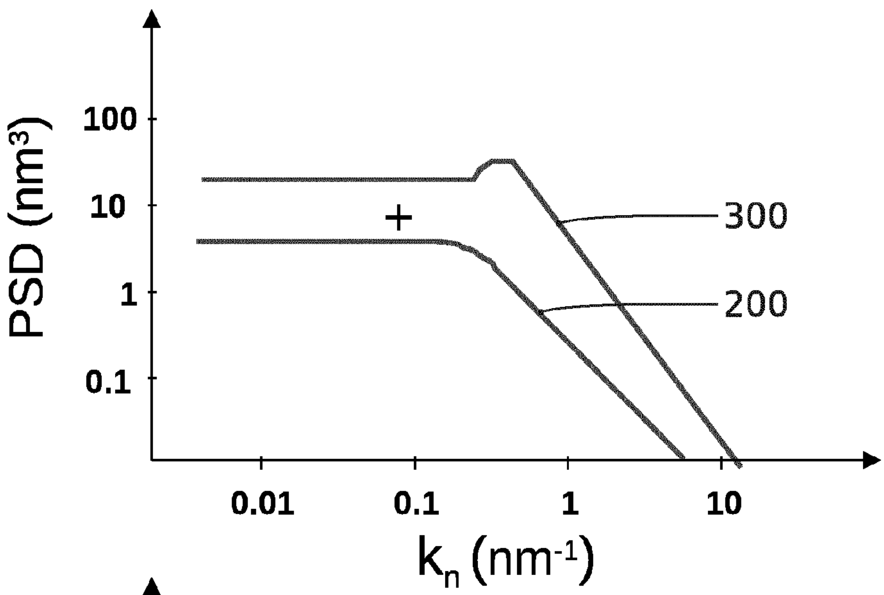


FIG. 9B

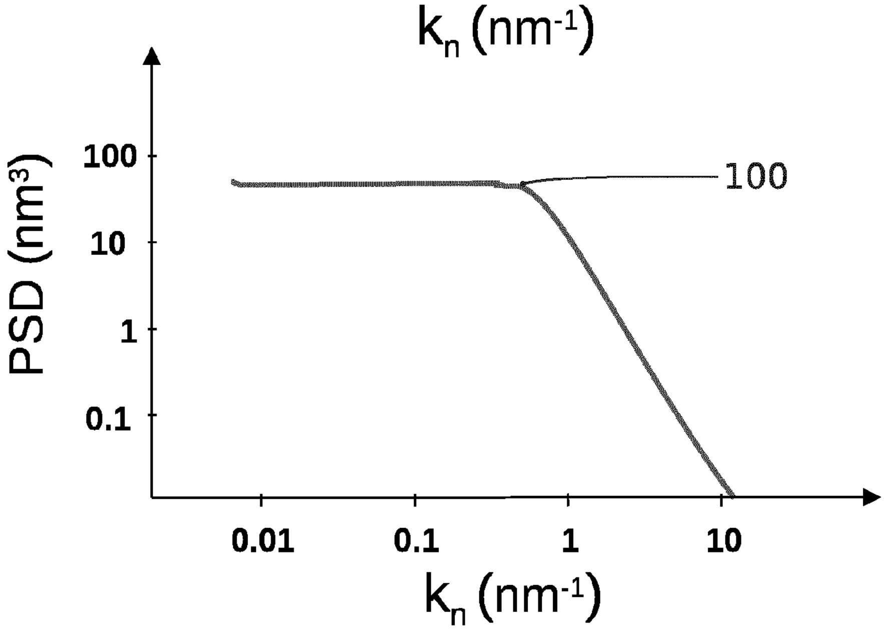


FIG. 9C

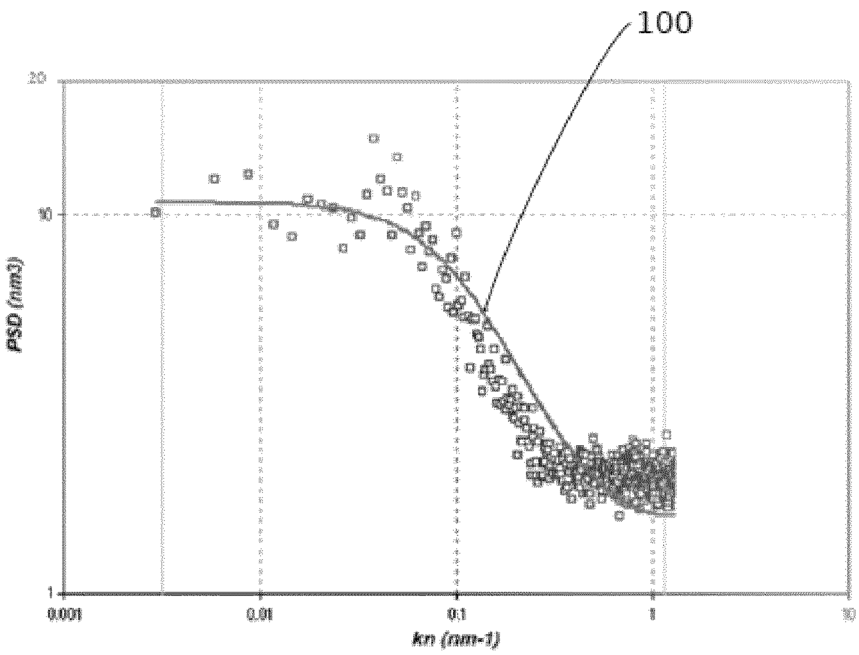
100
20
10
1
PSD (nm3)
0.001
0.01
0.1
1
10
kn (nm-1)

FIG. 10

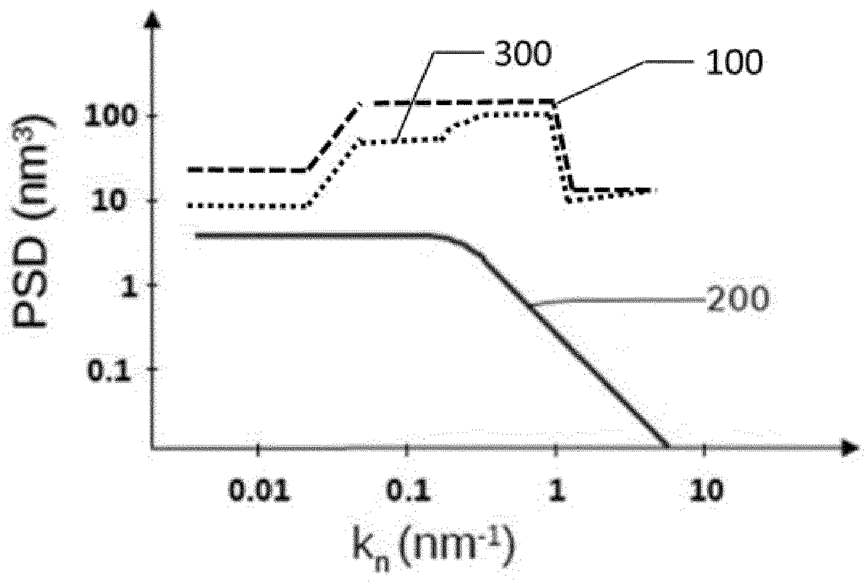
300
100
100
10
1
0.1
PSD (nm³)
200
0.01
0.1
1
10
kn (nm-1)

FIG. 11

Europäisches Patentamt
European Patent Office
Office européen des brevets

# RAPPORT DE RECHERCHE EUROPEENNE

Numéro de la demande
EP 20 20 1618

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X,D<br><br><br><br><br><br><br><br><br>Y | RECHE JÉRÔME ET AL: "Manufacturing of roughness standard samples based on ACF/PSD model programming", PROCEEDINGS OF SPIE; [PROCEEDINGS OF SPIE ISSN 0277-786X VOLUME 10524], SPIE, US, vol. 10775, 19 septembre 2018 (2018-09-19), pages 1077519-1077519, XP060110811, DOI: 10.1117/12.2327095 ISBN: 978-1-5106-1533-5<br>* pages 1,3,4 *<br>* pages 6,7,9,10 * | 1-4,8, 14,15<br><br><br><br><br><br><br><br>5-7,9-13 | INV.<br>G03F7/20<br>G01B15/04<br>G01B15/08<br>H01J37/26 |
| Y | BONAM RAVI ET AL: "An OCD perspective of line edge and line width roughness metrology", PROCEEDINGS OF SPIE; [PROCEEDINGS OF SPIE ISSN 0277-786X VOLUME 10524], SPIE, US, vol. 10145, 28 mars 2017 (2017-03-28), pages 1014511-1014511, XP060087817, DOI: 10.1117/12.2258196 ISBN: 978-1-5106-1533-5<br>* pages 1-3 * | 5,6,9,10 | |
| | | | DOMAINES TECHNIQUES RECHERCHES (IPC) |
| Y | BONAM RAVI ET AL: "Comprehensive analysis of line-edge and line-width roughness for EUV lithography", PROCEEDINGS OF SPIE; [PROCEEDINGS OF SPIE ISSN 0277-786X VOLUME 10524], SPIE, US, vol. 10143, 24 mars 2017 (2017-03-24), pages 101431A-101431A, XP060088041, DOI: 10.1117/12.2258194 ISBN: 978-1-5106-1533-5<br>* pages 6-10 * | 7,11-13 | G03F<br>G01B<br>H01J |
| A | US 2007/207394 A1 (DERSCH UWE [DE] ET AL) 6 septembre 2007 (2007-09-06)<br>* alinéas [0014], [0072] - [0087] * | 1-15 | |

1

Le présent rapport a été établi pour toutes les revendications

| Lieu de la recherche | Date d'achèvement de la recherche | Examinateur |
|---|---|---|
| Munich | 5 mars 2021 | Roesch, Guillaume |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE RELATIF A LA DEMANDE DE BREVET EUROPEEN NO.** EP 20 20 1618

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-03-2021

| Document brevet cité au rapport de recherche | Date de publication | Membre(s) de la famille de brevet(s) | Date de publication |
|---|---|---|---|
| US 2007207394 A1 | 06-09-2007 | DE 102007010581 A1 | 18-10-2007 |
| | | EP 1832927 A1 | 12-09-2007 |
| | | JP 4673863 B2 | 20-04-2011 |
| | | JP 2007298954 A | 15-11-2007 |
| | | KR 20070091573 A | 11-09-2007 |
| | | TW I358607 B | 21-02-2012 |
| | | US 2007207394 A1 | 06-09-2007 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description


- **BUNDAY, B. D. ; BISHOP, M ; VILLARRUBIA, J. S. ; VLADAR, A. E.** CD-SEM measurement line-edge roughness test patterns for 193-nm lithography. *Microlithogr,* 2003, 674-688
- *International Society for Optics and Photonics,* 2003
- Manufacturing of roughness standard samples based on ACF/PSD model programming. **RECHE, J. ; BESACIER, M. ; GERGAUD, P. ; BLANCQUAERT, Y.** 34th Eur. Mask Lithogr. Conf. SPIE, 2018